Europäisches Patentamt

European Patent Office

Office européen des brevets

(11) Publication number: 0 367 074 A2

# (12) EUROPEAN PATENT APPLICATION

(21) Application number: 89119724.6

(22) Date of filing: 24.10.89

(51) Int. Cl.⁵: H05K 3/26 , G03F 7/42

(30) Priority: 31.10.88 US 265117

(43) Date of publication of application:
09.05.90 Bulletin 90/19

(84) Designated Contracting States:
BE CH DE FR GB LI NL

(71) Applicant: LeaRonal, Inc.
272 Buffalo Avenue
Freeport, N.Y. 11520(US)

(72) Inventor: Martin, James L.
1753 Wilson Avenue
Merrick New York 11566(US)
Inventor: Whitlaw, Keith J.
64 Whiteknowle Park
Buxton Derbyshire(GB)
Inventor: Sepp, William
466 Grenadon Lane
North Babylon New York 11703(US)

(74) Representative: Hansen, Bernd, Dr.rer.nat. et al
Hoffmann, Eitle & Partner Patentanwälte
Arabellastrasse 4 Postfach 81 04 20
D-8000 München 81(DE)

(54) Preparing printed circuit boards for electroplating.

(57) A composition and process of use for a bath comprising a sulfonic acid as a cleaning or microetch solution in one of the preparation steps for preparing printed circuit boards for acid copper electroplating thereon. The metal surfaces of the copper laminate glass epoxy sheets which have been previously imaged with a photoimageable dry film resist must be cleaned to remove any organic residues of the resist which remain to avoid causing defects in the electroplated copper. The sulfonic acid solution may also contain surface active agents, complexing agents, chelating agents, or other salts such as phosphates, polyphosphates, sulfates, sulfonates or chlorides. The additives are soluble, free-rinsing, and stable in the acid solution and exhibit the required cleaning action on the surface of the copper.

## PREPARING PRINTED CIRCUIT BOARDS FOR ELECTROPLATING

Field of the Invention:

The invention relates to the manufacture of printed circuit boards from copper-coated plastic sheets, and more particularly to the preparation steps prior to copper electroplating when the laminate has been imaged with fully aqueous photoimageable dry film resists.

Background of the Invention

Many printed circuit boards are manufactured from copper-coated platic sheets which have been imaged with a photoimageable dry film resist. These dry films are commonly available to the industry and they are manufactured by such companies as Dupont, Morton-Thiokol, Hitatchi, Hercules, and others. The copper laminate can generally include a copper foil adhered to a plastic sheet, or a layer of copper electrolessly deposited upon a plastic sheet. In the manufacturing process, the copper laminate is coated with the photoimageable dry film, a photographic negative of the circuit pattern is placed over the film, and the composite exposed to actinic light. The light causes the exposed portions of the resist to polymerize, whereas the unexposed portions covered by the negative remain unpolymerized. The photographic negative is then removed and the board is developed by washing away the unexposed portions (the portions that were shielded from the light) using a developer that is capable of dissolving the unexposed film while at the same time leaving the exposed polymerized film intact. Bare copper on the sheet is now uncovered only in the desired areas which require copper plating at the next stage of the process. All other areas are covered by the polymerized dry film resist. The next step is copper plating, which is normally carried out in an acid copper plating bath using copper sulfate, sulfuric acid and certain additives.

It can be seen during the imaging process that the initial copper layer has been exposed to the organic matter of the photoimageable dry film, the chemicals present in the developer, and other incidental contaminants during handling and storage. These contaminants must be completely removed from the copper in order to achieve an acceptable copper deposit thereon from the copper electroplating operation. The preparation procedure must be capable of completely removing all contamination, thereby exposing clean, unoxidized copper to the acid copper plating bath. A preparation procedure that is commonly used includes the following steps: 1) immerse the board into an acid cleaner for a few minutes, 2) thoroughly rinse, 3) microetch the copper surface in a persulfate or peroxysulfuric etching solution to remove about 10 to 20 microinches therefrom, 4) thoroughly rinse, 5) dip in 10% sulfuric acid; and 6) electroplate copper to the desired thickness.

A critical step in this cycle is the initial acid cleaner which must be capable of removing all organic films and contamination present on the copper laminate in order to enable a satisfactory electrodeposit of copper to be obtained from the acid copper electroplating bath. If any organic films remain on the copper surface after the cleaning step, they must then be removed completely in the microetch step.

The photoimageable dry films are generally classified into three types: solvent, semi-aqueous, and fully aqueous. The solvent type is such that the developer used contains relatively large amounts of a chlorinated organic solvent. This solvent is generally effective in removing both the film and most residues therefrom. However, the developers for the semi-aqueous or fully aqueous films are not as effective for removal of such residues. The semi-aqueous film utilizes a developer that is a mixture of water, an alkali, and some organic solvent. The fully aqueous film requires a developer that consists merely of an aqueous alkaline solution. Developing solutions are discarded after a certain period of use, with the fully aqueous developer being much easier to dispose of because it does not contain organic solvents. For this reason, the fully aqueous dry films are preferred for use by a majority of printed circuit board manufacturers. On the other hand, the fully aqueous developers are less capable of washing away organic films from the exposed copper, which must be acid copper electroplated. It is therefore more important when using fully aqueous films to have a preparation procedure prior to acid copper electroplating capable of removing all the organic matter on the copper surface.

The problem generally encountered by industry when using fully aqueous resists is a certain type of pitting which is seen after the acid copper electroplating step. These pits take place only in the electrodeposited copper and not on the surface of the original copper laminate. It is believed that these pits are caused by organic contamination remaining on the surface of the copper prior to plating, the contamination not being completely removed during the preparation procedure. It is believed that the

2

organic contamination is mainly residuals from the dry film left behind on the copper surface after the developing step.

Prior art cleaning solutions all contain an acidic component of an organic or inorganic acid, since alkaline cleaners are not satisfactory when residues from organic photoresists are to be removed. These solutions generally contain a surface active agent and sometimes a complexing or chelating agent. Many different formulations have been tried with only limited success in resolving the above-described pitting problem.

These dry photoresist films are based on photosensitive resins that usually contain acrylates, polyacrylates, or other polymerizable materials. All fully aqueous dry film photoimageable resists have been known to leave residues after developing which promotes the same "difficult-to-clean" copper surface that can result in pitting of the subsequent copper electrodeposit. This invention discloses a pretreatment step of a cleaning and/or microetch solution that is specifically designed to remove all remaining organic residues from the copper surface so that the subsequent electrodeposit will be completely free of pitting or other similar defects.

Detailed Description of the Invention

This invention relates to a special cleaning or microetch solution for use in the manufacture of printed circuit boards. In particular, these solutions are intended to remove organic residues from photoimageable, semi-aqueous or fully aqueous dry film resists which have been developed to produce the desired circuit pattern on the board. These resists have a tendency to leave a greater amount of residue because they are developed by water based components rather than by organic solvents.

It has now surprisingly been found that the problem of pitting of the copper electrodeposit due to such residues can be essentially eliminated when using an organic sulfonic acid, in particular, a liquid alkyl sulfonic acid having between one and five carbon atoms, in the cleaning solution. The most preferred acid is methyl sulfonic acid. When these acids are used, the subsequent copper electrodeposits are found to be free of pitting or similar defects. Alkylol sulfonic acids can also be utilized in these cleaning solutions, but these are less compatible with the environment and for that reason are not preferred. Surfactants and complexing agents can also be included in combination with this acid to enhance the cleaning action for removal of common soils and fingerprints, with the alkyl sulfonic acid providing the cleaning capability for removal of organic residues from the photoresist film.

The amount of sulfonic acid in the cleaning solution is not critical and can vary from 2 grams/liter to 200 grams/liter or more with 30 grams/liter preferred. The temperature of the cleaning solution can vary from room temperature to 150°F, with 100-130°F preferred. The immersion time for the board can vary from 1 to 10 minutes, with 4 to 5 minutes preferred. This cleaning solution can advantageously also contain one or more of the generally known surfactants, with the quantities thereof generally ranging from 0.1 to 5 grams/liter, with about 1 gram/liter preferred. Any anionic, non-ionic, or cationic surfactant can be used provided that it is soluble, free-rinsing, and stable in the acid solution, and that it complements the required cleaning action on the copper surface. Other salts, such as ammonium chloride, sodium sulfate, or sodium phosphate, commonly used in the art for particular cleaning purpose, and/or a salt of the alkyl sulfonic acid can optionally be added to the solution to improve its cleaning action.

Complexing agents may be used in the cleaning solution to complex copper ions which may be present due to the action of the cleaning solution on the copper areas of the board. These complexing agents are well known in the art and are used to assist in the dissolution of metal ions in the solution. As one skilled in the art would realize, such metal ions are not intentionally added to the solution, but may be present from the action of the cleaning solution on metal parts or components which it may contact.

When using an alkyl sulfonic acid as the cleaning solution, it is not necessary to add the organic solvents which are commonly used in the prior art. Butyl cellosolve can be included if desired, but, the waste disposal of such a cleaner is far more difficult than for cleaning solutions based on the sulfonic acid alone. The cleaning solutions of this invention have far less of a waste disposal problem because they do not contain the chelating agents or organic solvents which would make waste disposal more difficult.

The alkyl sulfonic acid solution can be used with or without further additives for the removal of organic residuals from the developed photoresist. It is possible to use only the acid for this purpose as a dip or soak, then followed by any conventional prior art cleaner (with or preferably without solvents) to remove the other residuals or contaminants.

The microetch that follows the cleaners of this invention can be conventional peroxysulfuric type or acidic persulfate type. The sulfuric acid dip following the microetch can also be the conventional 10% solution into which the boards are immersed for about 1 minute at room temperature. The acid copper plating solution that follows the sulfuric acid dip can also be any acid copper electroplating process commonly used by the industry.

A new microetch solution can be made using alkyl sulfonic acid in place of all or some of the sulfuric acid. If the microetch solution contains this organic acid, then it is not essential that it be present in the acid cleaning solution, although superior results can be achieved when it is included in both.

Examples

In the following examples, developed printed circuit boards were immersed into the cleaning solution for 5 minutes, rinsed, immersed into an acid or ammonium persulfate solution to obtain a microetch, rinsed, immersed into a 10% v/v sulfuric acid solution at room temperature for one minute, then transferred into a proprietary acid copper electroplating solution to deposit one mil of copper. The resultant copper electrodeposits were examined for pitting and other surface defects.

Example 1 (Comparative)

The cleaning solution contained the following components:

| Hydroxyacetic acid | 62.5 ml/l |
| Ethoxylated nonyl-phenol surfactant (12 moles ethylene oxide) | 3.1 g/l |
| Ammonium chloride | 12.5 g/l |
| Temperature | 120°F |

The resultant copper electrodeposit showed a high concentration of pits and other surface defects.

Example 2 (Comparative)

Same as Example 1 except that 5 ml/l of butyl cellusolve is added to the cleaner formulation. The resultant copper electrodeposit showed evidence of pitting and other surface defects but to a lesser degree than in Example 1.

Example 3

Same as Example 2 except that 40 ml/l of 70% methyl sulfonic acid is added to the cleaner formulation. The resultant copper electrodeposit showed no evidence of pits or other surface defects.

Example 4

The cleaning solution contained the following components:

| Methyl sulfonic acid (70%) | 40 ml/l |
| Triton X100 (Rohm & Haas) (ethoxylated octyl phenol surfactant) | 1 ml/l |
| Sodium sulfate | 40 g/l |
| Temperature | 105°F |

The resultant copper electrodeposit was free from any pits or other surface defects.

## Example 5

Same as Example 4 except that 6.25 ml/l of the surfactant Chemal LFL-47, an ethoxylated/propoxylated linear alcohol of chain length $C_{12}$-$C_{15}$ available from Chemax Inc., Greenville, South Carolina, was substituted for the Triton X100. The resultant copper electrodeposit was free from any pits or other surface defects.

## Example 6

Same as Example 4 except that 6.25 g/l of the surfactant Chemal ARX-653, an ethoxylated/propoxylated rosin resin acid available from Chemax, Inc., was substituted for the Triton X100. The resultant copper electrodeposit was free from any pits or other surface defects.

## Example 7

Same as Example 4 except that 3.1 g/l of an ethoxylated nonyl phenol surfactant (12 moles ethylene oxide) was substituted for the Triton X100. The resultant copper electrodeposit was free from any pits or other surface defects.

## Example 8

Same as Example 4 except that 2 ml/l of a sulfated ethoxylated bisphenol A surfactant (Synfac 8118, available from Milliken Chemical, Spartanburg, South Carolina) was substituted for the Triton X100. The resultant copper electrodeposit was free from any pits or other surface defects.

## Example 9

Same as Example 4 except that 2 ml/l of a sulfonated ethoxylated naphthol (Polymax XPA 755, available from Chemax, Inc.) was substituted for the Triton X100. The resultant copper electrodeposit was free from any pits or other surface defects.

## Example 10

Same as Example 4 except that 1 ml/l lauryl myristyl dimethyl amine oxide (Schercamox DMA, available from Scher Chemicals, Inc., Clifton, New Jersey) was substituted for Triton X100. The resultant copper electrodeposit was free from any pits or other surface defects.

## Example 11

Same as Example 4 except that 16.5 g/l sodium chloride was substituted for the sodium sulfate. The resultant copper electrodeposit was free from any pits or other surface defects.

## Example 12

Same as Example 4 except that 38.8 g/l potassium dihydrogen phosphate was substituted for the sodium sulfate. The resultant copper electrodeposit was free from any pits or other surface defects.

## Example 13

Same as Example 4 except that 12.5 g/l ammonium chloride was substituted for the sodium sulfate.

The resultant copper electrodeposit was free from any pits or other surface defects.

Example 14

The developed printed circuit board was initially immersed into a solution of 40 ml/l 70% methyl sulfonic acid at 100° F for 2 minutes and then processed as in Example 1. The resultant copper electrodeposit was free from any pits or other surface defects.

Example 15

Same as Example 14 except that 5 ml/l polyoxyalkylated butanol (MW = 1700) added to the acid to form a pre-dip formulation. The resultant copper electrodeposit was free from any pits or other surface defects.

Example 16 (Comparative)

The cleaning a solution contained the following components:

| Hydroxyacetic acid | 37.5 ml/l |
| Ammonium chloride | 7.5 g/l |
| Ethoxylated nonyl phenol surfactant (12 moles ethylene oxide) | 3.1 g/l |
| Temperature | 120° F |

The cleaning step was followed by a standard peroxysulfuric acid etching solution. The resultant copper electrodeposit exhibited a high concentration of pits and other surface defects.

Example 17

Same as Example 16 except that the etching solution was replaced by one containing 80% sulfuric acid and 20% methyl sulfonic acid instead of sulfuric acid alone. The resultant copper electrodeposit was free from any pits or other surface defects.

Example 18

Same as Example 16 except that the etching solution was replaced by one containing methyl sulfonic acid in place of the sulfuric acid. The resultant copper electrodeposit was free from any pits or other surface defects.

While it is apparent that the invention herein disclosed is well calculated to fulfill the objects above stated, it will be appreciated that numerous modifications and embodiments may be devised by those skilled in the art, and it is intended that the appended claims over all such modifications and embodiments as fall within the true spirit and scope of the invention.

**Claims**

1. A cleaning solution for removal of organic residues from a metal layer of a printed circuit board which has been imaged with a photoresist, comprising a sulfonic acid in an amount sufficient to remove said organic residues and a surfactant; said solution having a temperature of between about 70 and 150° F.

2. The solution of claim 1 wherein the sulfonic acid is an alkyl sulfonic acid having between 1 and 5 carbon atoms in the alkyl group.

3. The solution of claim 1 further comprising a salt which is soluble in the solution for improving its cleaning action.

4. The solution of claim 3 wherein the salt is a chloride, sulfate, phosphate, polyphosphate, or sulfonate.

5. The solution of claim 1 wherein the temperature of the solution is between 100 and 130° F.

6. The solution of claim 1 further comprising a complexing agent to assist in the dissolution of metal ions into the solution.

7. The solution of claim 6 wherein the complexing agent is hydroxy acetic acid.

8. The solution of claim 1 wherein the surfactant is an alkylene oxide condensation compound.

9. The solution of claim 1 further comprising an organic solvent for improving the cleaning action of the solution.

10. The solution of claim 9 wherein the solvent is an alkyl cellosolve compound.

11. In a method for preparing a printed circuit board wherein a metal surface of said board is electroplated with copper after removal of a photoresist therefrom, the improvement which comprises contacting said metal surface with a cleaning solution comprising a sulfonic acid in an amount sufficient to remove organic residues of said photoresist from said metal surface prior to said electroplating step so as to avoid or minimize pitting defects in the resulting copper electrodeposit thereupon.

12. The method of claim 11 wherein the sulfonic acid is selected from alkyl sulfonic acids having one to five carbon atoms in the alkyl group.

13. The method of claim 11 wherein the metal surface of the board is applied as a foil or by electroless plating.

14. The method of claim 11 wherein the cleaning solution is applied to the metal surface after developing of said photoresist.

15. The method of claim 14 wherein the photoresist is developable by aqueous or semiaqueous solutions.

16. The method of claim 11 wherein the cleaning solution is applied to the metal surface as part of a microetching step.

17. The method of claim 11 wherein said cleaning solution further comprises a surfactant and is maintained at a temperature of between 70 and 150° F.

18. The method of claim 11 wherein said cleaning solution further comprises a salt which is soluble therein for improving its cleaning action.

19. The method of claim 11 wherein said cleaning solution includes a complexing agent to assist in the dissolution of metal ions therein.

20. The method of claim 11 wherein said cleaning solution further comprises an agent for etching metal from said metal surfaces.